(19) Europäisches Patentamt
European Patent Office
Office européen des brevets

(11) Publication number: **0 442 755 A2**

# (12) EUROPEAN PATENT APPLICATION

(21) Application number: **91301240.7**

(22) Date of filing: **15.02.91**

(51) Int. Cl.[5]: **G03F 7/021**, G03F 7/085, G03F 7/32, C08F 212/08, C08F 232/04

(30) Priority: **16.02.90 US 480733**

(43) Date of publication of application: **21.08.91 Bulletin 91/34**

(84) Designated Contracting States: **DE FR GB IT NL**

(71) Applicant: **Wu, Chengjiu**
**8 Lynnfield Drive**
**Morristown, New Jersey (US)**
Applicant: **Mooring, Anne M.**
**107 W. Kingswood Drive**
**Williamsburg, Virginia (US)**
Applicant: **Yardley, James T.**
**40 MacCulloch Avenue**
**Morristown, New Jersey (US)**

(72) Inventor: **Wu, Chengjiu**
**8 Lynnfield Drive**
**Morristown, New Jersey (US)**
Inventor: **Mooring, Anne M.**
**107 W. Kingswood Drive**
**Williamsburg, Virginia (US)**
Inventor: **Yardley, James T.**
**40 MacCulloch Avenue**
**Morristown, New Jersey (US)**

(74) Representative: **De Minvielle-Devaux, Ian Benedict Peter et al**
**CARPMAELS & RANSFORD 43, Bloomsbury Square**
**London WC1A 2RA (GB)**

(54) **Alternating copolymer of styrene and 2-diazo-4-cyclopentene-1,3-dione.**

(57) A linear alternating copolymer of 2-diazo-4-cyclopentene-1,3-dione and styrene is obtained under mild radical conditions. This copolymer is deep u.v. (260-300 nm) and/or KrF excimer laser (248 nm) photosensitive. A single-component, negative or positive deep u.v. photoresist of this copolymer is provided. A crosslinked 2-diazo-4-cyclopentene-1,3-dione-styrene copolymer is prepared by diazo transfer reaction of the linear alternating 4-cyclopentene-1,3-dione-styrene copolymer. 10-Oxa-exo-tricyclo (5.2.1.0$^2$,$^6$)-deca-8-ene-4-diazo-3,5-dione, a precursor of 2-diazo-4-cyclopentene-1,3-dione, is prepared by an improved method involving a polymer reagent.

EP 0 442 755 A2

Background of the Invention

The present invention relates to polymeric photosensitizers which are copolymers of styrene and 2-diazo cyclopentene-1,3-dione. These compounds can be used as negative or positive photoresists depending on the chosen processing conditions. In the most preferred embodiment they are single component, film forming materials which act as both binder resin and photosensitive in the traditional photoresist sense. Photoresists are materials which change their solubility in a developer solution after the photoresist has been exposed to actinic radiation, such as ultraviolet radiation. Photoresist compositions usually comprise a photosensitive compound, a film forming polymeric resin and a solvent. The photoresist composition is applied to a substrate which is to be patterned and the solvent is then removed, leaving the photoresist as a thin film covering the substrate. As a consequence of the exposure to radiation of the photoresist, a different solubility rate results between imagewise exposed arid unexposed portions of a resist film that yields a surface relief pattern after the development. Those photoresists which become more soluble in a developer solution in the exposed regions are referred to as "positive" photoresists. Those which become less soluble in the exposed regions are referred to as "negative" photoresists.

In the past, positive photoresists typically contained an aqueous alkali soluble resin, such as novolak resin or polyvinyl phenol and a diazonaphthoquinone sulfonic acid ester sensitizer. The resin and sensitizer are applied such as by spin-coating, spray-coating, or other suitable means from an organic solvent or solvent mixture onto a substrate, such as a silicon wafer. After imagewise exposure, the developer removes the non-image areas of the coated photoresist to produce a relief pattern in the photoresist film.

Most commercially available photoresist are such two-component systems consisting of a sensitizer and a polymer. The polymer part affords the desired film properties. The photosensitizer, which is dispersed in the polymer film decomposes or rearranges upon irradiation and controls the solubility of the whole matrix. If the decomposition product renders the film much more soluble in the developer solution than the original, the system is a positive photoresist ; if the decomposition product reacts with the polymer and makes the film virtually insoluble in the developer by crosslinking, the system is a negative photoresist. In most commercial photoresist compositions, the polymer is typically a phenolic resin which is weakly acidic and can dissolve in basic solutions or organic solvents. A typical positive photosensitizer is an appropriate diazonaphthoquinone, which is hydrophobic and inhibits the dissolution of the polymer matrix. Upon irradiation, the diazonaphthoquinone undergoes a rearrangement to give an indenecarboxylic acid, accelerating the dissolution process. Typical negative photosensitizers are bis-azide compounds which upon irradiation give nitrenes which can react with the polymer chain to form crosslinked compounds.

It is of considerable interest to produce a single polymer which has both the film properties and the photodecomposition characteristics of the conventional two component systems by, for example, attaching a photosensitive functional group to the polymer backbone. Most previous efforts have assembled a chromophore group into the polymer either as a pendant group or directly into the chain. Irradiation causes the polymer chain to degrade or crosslink. Methyl methacylate copolymers, sulfone copolymers and polystyrene derivatives are useful in this regard. Another approach is the development of polysilanes, in which the wavelength of absorption can be adjusted by chain length and the alkyl or aryl substituents. In these systems bond scission and volatilization result upon irradiation.

In the chemistry of chain scission of a high molecular weight polymer into lower molecular weight polymers, the energy of the deep u.v. light is sufficient to rupture bonds in the polymer chain, resulting in lower molecular weight materials of increased solubility. The most common example of this technique uses poly(methylmethacrylate). The primary drawback of this resist is the need for a high exposure dose to yield a sufficient difference in molecular weight.

It is essential that the mask pattern be accurately reproduced in the substrate etch pattern. To achieve this high degree of accuracy, the mask pattern must be well resolved by the photoresist layer. The laws of optics and diffraction dictate that resolution will improve as the wavelength of the irradiation is shortened. Thus, a photoresist capable of operating in the deep ultraviolet region (200-300nm) will be capable of higher potential resolution than those resists limited to operating in the near ultraviolet region (300-400nm).

Diazonaphthoquinone sulfonic acid esters are commonly used as sensitizers in conventional near u.v. photoresists. While these ester sensitizers are photoactive in the deep u.v., they exhibit several serious limitations for use as deep u.v. photosensitizers. These sensitizers exhibit intense absorptions in the deep u.v. region, making the resist composition excessively absorptive as well. These deep u.v. absorptions are also poorly photobleached by the exposing radiation so that the film's absorbance is not greatly diminished during the irradiation process. Ideally, the sensitizer photoproduct should be nonabsorbing in the region of irradiation used to expose the resist so that all absorbed light does useful chemistry, thereby maximizing sensitivity. These prior art sensitizers also possess near u.v. absorption bands which allow them to be used in conventional near u.v.

photoresists. HOwever, this near u.v. response would be considered a drawback in a true deep u.v. resist, as it would necessitate filtering the exposure source to remove long wavelength radiation to prevent degradation of the resolution.

This invention provides photosensitive compounds and compositions which contain sensitizers designed to operate effectively in the deep u.v. spectral region during the process of integrated circuit manufacture.

Other attempts have been made to design a photoresist system for the deep u.v. region. For example, UK patent Application No. 2,099,168 teaches ortho-nitrobenzyl groups attached to polymers and sensitizer molecules. The use of orthonitrobenzyl chemistry for photoresists is also taught in U.S. Pat. No. 3,849,137.

Another example of deep u.v. photoresist technology involves the use of deep u.v. excimer lasers of high instantaneous fluence to ablate away selected areas of the photoresist film. This laser photoablation is disclosed in U.S. Pat. 4,414,059.

Still another disclosure relating to deep u.v. sensitizers is found in European Patent Application 0 129 694, which describes compounds based on diazohomotetramic acid for use in photoresist compositions.

U.S. Patent 4,339,522 discloses 5-diazo meldrumacids ; EP84 105 544 discloses diazohomotetramic acid compounds ; U.S. 4,735,885 discloses deep u.v. photoresists formed from 1,3 disubstituted-5-diazobarbituric acid. Compounds having the 2-diazo-1,3-dione grouping are also known, as shown in U.S. 4,622,283 ; 4,284,706 ; 4,339,522 ; 4,624,908 and Japanese Patent 78127439. Each of the foregoing has its own shortcoming such as volatility, stability and solubility.

The invention provides a deep u.v. and/or excimer-laser (248 nm) sensitive photoresist system employing a copolymer of styrene and 2-diazo-cyclopentane-1,3-dione as a film forming deep u.v. photosensitizer.

Summary of the Invention

The invention provides a light sensitive film forming copolymer having structural formula

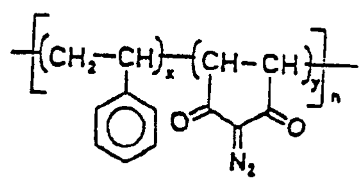

wherein the mol ratio of x to y ranges from about 1 :9 to about 9 :1, n ranges from about 5 to about 500, and the copolymer has a molecular weight of from about 1,000 to about 500,000.

The invention also provides a light sensitive composition comprising the foregoing copolymer in admixture with a solvent for said copolymer.

The invention further provides a photographic element comprising a substrate having a substantially uniform film of said copolymer coated on at least one surface of said substrate.

The invention still further provides a process for preparing a negative or positive photographic image which comprises in order :

i) coating a substrate with a light sensitive composition comprising a light sensitive, film forming copolymer having the structural formula

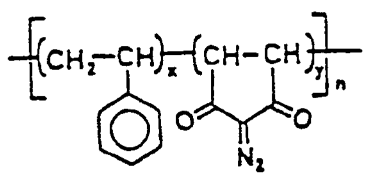

wherein the mol ratio of x to y ranges from about 1 :9 to about 9 :1, n ranges from about 5 to about 500, and the copolymer has a molecular weight of from about 1,000 to about 500,000 ; in admixture with a solvent for said copolymer ; and

ii) heating said coated substrate at a temperature of from about 20°C to about 100°C until substantially all of said solvent is dried off ; and

iii) imagewise exposing said composition to ultraviolet radiation in the range of from about 200nm to about 300nm ; and

iv) removing the non-image areas of said composition with a developer.

Detailed Description of the Preferred Embodiment

The copolymer is produced by introducing the diazo group before or after the polymerization process as shown in the following scheme :

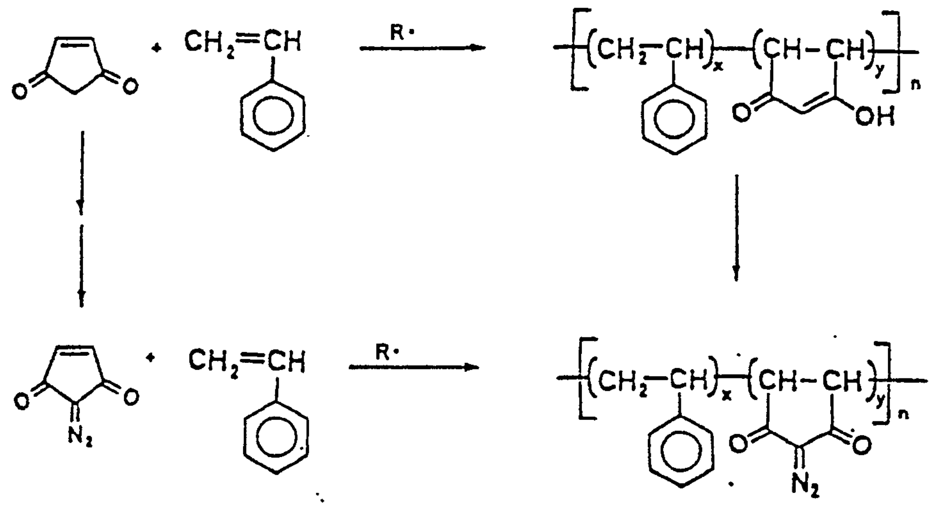


Copolymers of 4-cyclopentene -1,3-dione have been heretofore described (see Lamb, F.L. and Winston, A., Jour. Poly. Sci., Pt. A, 2 (1964), 4475 ; Winston, A. and Lamb, F.L., Jour. Poly. Sci., Pt. A-1 3 (1965), 583; and Winston, A. and Li, G.T.C., Jour. Poly. Sci., Pt. A-1 5 (1967), 1223.)

2-diazo-4-cyclopentene-1,3-dione was first successfully synthesized by M. Oda et al. (See Oda, M., and Kawanishi, S., Japanese Patent JP 78127495 (November 7, 1978) ;C.A. 90 (1978), 137666 ; and Oda, M. ; Kasari, M. ; and Kitahara, Y., Chem. Letters, (1977) 307.) This proceeds by the following scheme :

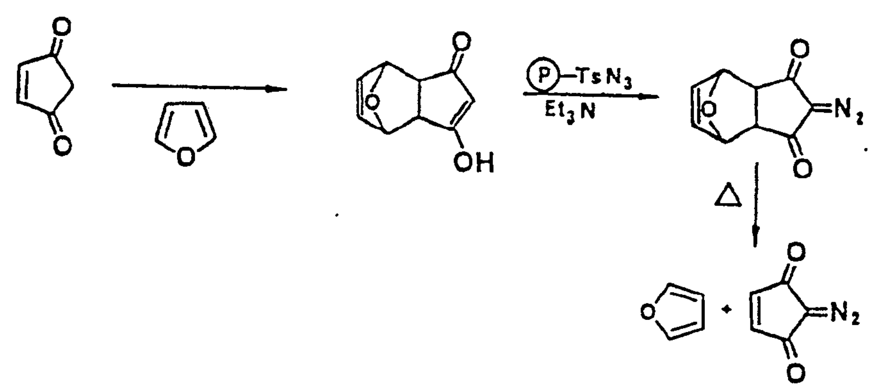


It has been found that the troublesome step is separating 10-oxa-exo-tricyclo[5.2.1.$0^{2,6}$-deca-8-ene-4-diazo-3,5-dione from the reaction mixture. The column separation is tedious, incomplete, and the reported yield of 81% was irreproducible. By using a polymer-bound tosyl azide technique (see Roush, W.R. ; Feitler, D. ; and Rebek, J., Tetrahedron Lett. (1974), 1391), one is able to get high yield in one column-pass. The polymer-bounded tosyl azide is prepared from macroeticular polystyrene-divinyl styrene beads (XAD-1, Rhom and Haas) by the above method and contains about 0.65 azide group per phenyl unit.

Polymerization and copolymerization of diazo cyclopentene dione has not been known heretofore. Although the diazo functionally is thermo- and light-labile, it can survive under mild radical conditions, particularly in those copolymerizations with high alternative tendency where the radical selectivity is high. From the apparent structural similarity of diazo cyclopentene dione with cyclopentene dione maleimide and maleic anhydride, they are assumed to have Q and e values close to cyclopentene dione or maleimide (as shown in Table 1) and thus diazo cyclopentene dione is expected to undergo alternative copolymerization with monomers having large Q and positive e values such as styrene.

Table 1: Q,e Values of Several 4-Unsaturated Cyclic Cyclic 1,3-Diones, 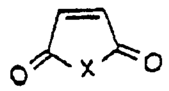

| X | C = $N_2$* | $CH_2$ | NH | O |
|---|---|---|---|---|
| Q | (>0.4)* | 0.42 | 0.94 | 0.86 |
| e | (>÷2)* | ÷2.43 | ÷2.86 | +3.69 |

*(estimated)

These compounds are u.v. transparent at >300nm, strongly absorb at about 250 nm, bleach upon irradiation, and the main photolysis products (in the presence of moisture) are cyclobutan-2-one-1-carboxylic acids and glutaric acids.

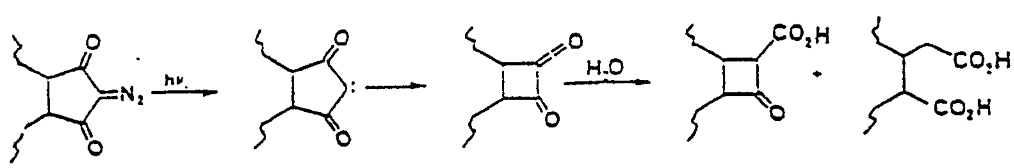


This invention incorporates 2-diazo-cyclopentane 1,3-dione units into a film forming polymer by copolymerizing with a vinyl containing monomer unit. One method is free radial copolymerizing a vinyl monomer, preferably styrene, with 2-diazo-cyclopentene-1,3-dione. The comonomers are preferably alternating. The skilled artisan may tailor the molecular weight according to the particular application desired. Molecular weights may range from about 1,000 to about 500,000 or more preferably from about 2,000 to about 400,000 and most preferably from about 4,000 to about 200,000. The mole ratio of vinyl monomer to dione may range from about 1 :9 to about 9 :1, more preferably about 1 :1.

The photosensitive composition is formed by blending the ingredients in a suitable solvent composition. In manufacturing the resist composition the photosensitive resin and optional other components are mixed with such solvents as propylene glycol mono-alkyl ether, propylene glycol alkyl ether acetate, butyl acetate, xylene, ethylene glycol monoethyl ether acetate, and most preferably propylene glycol mono-methyl ether acetate, chloroform, 1,1,2,2 tetrachloroethane cyclohexanone, methylene chloride, among others may also be used. Other optional ingredients such as colorants, dyes, anti-striation agents, leveling agents, plasticizers, adhesion promoters, speed enhancers, solvents and such surfactants as non-ionic surfactants may be added before the solution is coated onto a substrate. Examples of dye additives that may be used together with the photoresist compositions of the present invention include Methyl Violet 2B (C.I. No. 42535), Crystal Violet (C.I. 42555), Malachite Green (C.I. No. 42000), Victoria Blue B (C.I. No. 44045) and Neutral Red (C.I. No. 50040) at one to ten percent weight levels, based on the combined weight of non-solvent components. The dye additives help provide increased resolution by inhibiting back scattering of light off the substrate.

Anti-striation agents may be used at up to a five percent weight level, based on the combined weight of all non-solvent components. Plasticizers which may be used include, for example, phosphoric acid tri-(beta-chloroethyl)-ester ; stearic acid ; dicamphor ; polypropylene ; acetal resins ; phenoxy resins ; and alkyl resins at one to ten percent weight levels, based on the combined weight of all non-solvent components. The plasticizer additives improve the coating properties of the material and enable the application of a film that is smooth and of uniform thickness to the substrate. Adhesion promoters which may be used include, for example, beta-(3,4-epoxy-cyclohexyl)-ethyltrimethoxysilane ; p-methyl-disilane-methyl methacrylate ; vinyltrichlorosilane ; and gamma-amino-propyl triethoxysilane up to a 4 percent weight level, based on the combined weight of non-solvent components. Development speed enhancers that may be used include, for example, picric acid, nicotinic acid or nitrocinnamic acid by a weight level of up to 20 percent, based on the combined weight of non-solvent components. These enhancers tend to increase the solubility of the photoresist coating in both the exposed and unexposed areas, and thus they are used in applications when speed of development is the overriding consideration even though some degree of contrast may be sacrificed ; i.e., while the exposed areas of the photoresist coating will be dissolved more quickly by the developer, the speed enhancers will also cause a larger loss of photoresist coating from the unexposed areas.

The coating solvents may be present in the overall composition in an amount of up to 95% by weight of the solids in the composition. Non-ionic surfactants that may be used include, for example, nonylphenoxy poly(ethyleneoxy) ethanol ; octylphenoxy ethanol at up to 10% weight levels, based on the combined weight of novolak and sensitizer.

The prepared resist solution, can be applied to a substrate by any conventional method used in the photoresist art, including dipping, spraying, whirling and spin coating. When spin coating, for example, the resist solution can be adjusted with respect to the percentage of solids content in order to provide coating of the desired thickness given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures ; gallium arsenide and other such Group III/V compounds. The photoresist coatings produced by the above described procedure are particularly suitable for application to thermally grown silicon/silicon dioxide-coated wafers such as are utilized in the production of microprocessors and other miniaturized integrated circuit components. An aluminum/aluminum oxide wafer can be used as well. The substrate may also comprise various polymeric resins especially transparent polymers such as polyesters. The substrate may have an adhesion promoted layer of a suitable composition such as hexa-alkyl disilazane.

The resist composition solution is then coated onto the substrate, and the substrate is temperature treated at approximately 80° to 100°C for from about 1 to about 45 minutes. This temperature treatment is selected in order to reduce the concentration of residual solvents in the photoresist while not causing substantial thermal degradation of the photosensitizer. In general one desires to minimize the concentration of solvents and thus this temperature treatment is conducted until substantially all of the solvents have evaporated and a thin coating of photoresist composition, on the order of a micron in thickness, remains on the substrate. In a preferred embodiment the temperature is conducted at from about 20°C to about 100°C. A more preferred range is from about 70°C to about 95°C. The treatment is conducted until the rate of change of solvent removal becomes relatively insignificant. The temperature and time selection depends on the resist properties desired by the user as well as equipment used and commercially desired coating times. Commercially acceptable treatment times for hot plate baking are those up to about 10 minutes, more preferably up to about 5 minutes. In one example, a 1 minute treatment at 90°C is useful. The coated substrate can then be exposed to actinic radiation, especially deep ultraviolet x-ray, electron beam, ion beam or laser radiation, in any desired pattern, produced by use of suitable masks, negatives, stencils, templates, etc.

The exposed resist-coated substrates are next developed by immersion in an alkaline developing solution or organic solvent depending on whether a positive or negative image is desired. The solution is preferably agitated, for example, by nitrogen burst agitation. The substrates are allowed to remain in the developer until all, or substantially all, of the resist coating has dissolved from the exposed areas. Developers may include aqueous solutions of ammonium or alkali metal hydroxides. One preferred hydroxide is tetramethyl ammonium hydroxide. The most preferred developer is AZ Developer available commercially from the AZ Photoresist Products group of Hoechst Celanese Corporation, Somerville, New Jersey. After removal of the coated wafers from the developing solution, a post-development heat treatment or bake may be employed to increase the coating's adhesion and chemical resistance to etching solutions and other substances. The post-development heat treatment can comprise the oven baking of the coating and substrate below the coating's softening point. The industrial applications, particularly in the manufacture of microcircuitry units on silicon/silicon dioxide-type substrates, the developed substrates may be treated with a buffered, hydrofluoric acid base etching solution. The resist compositions of the present invention are resistant to acid-base etching solutions and provide effective protection for the unexposed resist-coating areas of the substrate.

The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention.

EXAMPLE 1

A linear 1 :1 alternating copolymer of styrene and 4-cyclopentene-1,3-dione can be obtained under the following conditions : feed monomer ratio of styrene/4-cyclopentene-1,3-dione as indicated in Table 1 ; cyclohexanone as solvent, 2,2'-azobis(2,4-dimethyl-4-methoxy valeronitrile (Vazo-33 by DuPont) as initiator in an amount of 0.06 mol% of total monomer ; 1-dodecanethiol as chain modifier in an amount of 0.2 mole% of total monomer ; at a reaction temperature of 20°C. After 40-65 hours, the copolymer is precipitated by pentane and

then Soxlet extracted by pentane and ether. The copolymer readily dissolves in DMF, DMSO, and $MeOH/Et_3N$. The copolymer composition is analyzed by proton NMR by measuring the ratios of phenyl-H (6.2-7.6 ppm) and enol-H (5.0 ppm). A model study indicates the cyclopentane-1,3-dione unit is completely in its enol form. The results are summarized in Table 2.

Table 2: Copolymerization of Styrene-Cyclopentanedione

| No. | Polymerization Time (hours) | Conversion (%) | Feed Composition (Styrene in Monomer) (Mol Fraction) | Copolymer Composition (Styrene in Copolymer (Mol Fraction) |
|---|---|---|---|---|
| 1 | 65 | 78 | 0.53 | 0.52 |
| 2 | 40 | 30 | 0.50 | 0.51 |
| 3 | 65 | 56 | 0.61 | 0.52 |

The cyclopentane-1,3-dione unit in the copolymer can be transformed into a cyclopentane-2-diazo-1,3-dione by diazo transfer upon reacting the copolymer with tosyl azide and triethyl amine in DMF or DMSO at room temperature. The diazo group in the copolymer is detected by a sharp 2130 $cm^{-1}$ peak in an IR spectrum. After irradiation with deep u.v. light, the diazo group decreases and the absorption of the carboxyl group (1773 $cm^{-1}$) increases.

Example 2

The copolymerization of diazo cyclopentene dione with styrene is carried out under conditions similar to the previously described styrene/cyclopentene dione copolymerization of example 1 : feed monomer ratio of 1/1 ; solvent, cyclohexanone ; initiator, Vazo-33, 0.08 mol% of total monomer ; chain modifier, 1-dodecanethiol, 0.14 mol% of total monomer ; temperature, 20°C. After 60 hours, the copolymer is precipitated by methanol and then Soxlet-extracted with ether. The conversion is 90%. The polymer is shown to be linear as it dissolves readily in methylene chloride, chloroform or 1,1,2,2-tetrachloroethane to form a homogeneous solution and thin films can be cast from the solution. The polymer appears to be a 1 :1 copolymer by proton NMR as the ratio of phenyl-H (6.0-7.5 ppm) to aliphatic-H (1.5-3.8 ppm) is approximately 1 :1 (± 10%). The diazo groups remain intact in the copolymer as indicated by the presence of the sharp peak at 2130 $cm^{-1}$ in the IR spectrum. Upon irradiation with UV, this peak diminishes while the 1790 (carboxyl) and 3200 (hydroxyl) $cm^{-1}$ peaks increase. The u.v. spectra of a copolymer film cast from chloroform solution shows maximum absorbtion (lambda max) at 254 and 221 nm ; the 254 nm peak bleachs upon u.v. illumination, indicating this copolymer is deep u.v. and/or excimer laser (248 nm) light-sensitive.

The copolymer is more thermally stable than its low molecular weight analog ; monomeric cyclopentane-2-diazo-1,3-dione. The exothermic de-nitrogenation step in the copolymer occurs at 180-190°C instead of 160°C in the monomeric model. It is believed that this is a matrix effect in which the rigid polymer backbone inhibits energy transfer to the thermolabile functional groups.

Example 3

Silicon wafers are spin-coated from a 1,1,2,2-tetrachloroethane solution of the styrene/diazo cyclopentene dione copolymer. The film thickness is 0.3-0.6 microns. The solvent is removed by vacuum. The film is irradiated through a step tablet in direct contact with the film by u.v. light from a high pressure Hg-Xe lamp filtered through a 260 ± 25 nm band-pass filter. The irradiated films are then developed with methylene chloride for the negative resist or 0.2N KOH for the positive resist. In the negative photoresist application, the unirradiated part is completely cleared out with no loss of the irradiated part at a dose of 420 $mJ/cm^2$.

In a positive photoresist application, the irradiated part is not fully removed by aqueous base. This can be explained by the hydrophobicity of the film and its inability to retain water to trap the active keto-ketene formed by irradiation. The excess ketenes may then react with the polymer chain or themselves to cause crosslinking. This positive resist is useful for larger geometry applications as is or one may reduce the hydrophobicity or increase the water content of the film. This may be accomplished by adding hydrophilic additives.

## Claims

1. A light sensitive film forming copolymer having the structural formula

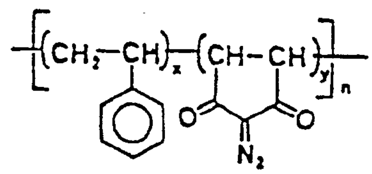

wherein the mol ratio of x to y ranges from 1 :9 to 9 :1, n ranges from 5 to 500, and the copolymer has a molecular weight of from 1,000 to 500,000.

2. A light sensitive, film forming copolymer containing comonomers of 2-diazo-4-cyclopentene-1,3-dione and a vinyl monomer in a respective mol ratio of from 1 :9 to 9 :1 and having a molecular weight in the range of 4,000 to 200,000.

3. The copolymer of claim 2 wherein the monomers are alternating and the mol ratio of monomers is approximately 1 :1.

4. A light sensitive composition comprising the copolymer of any of claims 1-3 in admixture with a solvent for the copolymer.

5. The composition of claim 4 wherein the solvent is selected from diglyme, propylene glycol monoalkyl ether and propylene glycol monoalkyl ether acetate.

6. The composition of claim 4 or 5 which further comprises one or more compounds selected from colorants, dyes, anti-striation agents, leveling agents, plasticizers, adhesion promoters, speed enhancers, and surfactants.

7. A photographic element comprising a substrate having a substantially uniform film coated on at least one surface of the substrate, characterised in that the film comprises a light sensitive film forming copolymer according to any of claims 1-3.

8. The photographic element of claim 7 wherein the film further comprises one or more compounds selected from colorants, dyes, anti-striation agents, leveling agents, plasticizers, adhesion promoters, speed enhancers, solvents and surfactants.

9. The photographic element of claim 7 or 8 wherein the substrate is selected from silicon, aluminum, polymeric resins, silicon dioxide, doped silicon dioxide, silicon nitride, tantalum, copper polysilicon, ceramics, aluminum/copper mixtures, gallium arsenide and Group III/V compounds.

10. A process for preparing a negative or positive photographic image which comprises in order :
    i) forming a photographic element in accordance with any of claims 7-9 by a method involving coating on the substrate a composition in accordance with any of claims 4-6 and heating the coated substrate at a temperature of 20°C to 100°C until substantially all of the solvent is dried off ; and
    ii) imagewise exposing the composition to ultraviolet radiation in the range of from 190 nm to 300 nm ; and
    iii) removing the non-image areas of the composition with a developer.

11. The process of claim 10 wherein the developer comprises an aqueous alkaline solution or methylene chloride.

12. The process of claim 11 wherein the developer comprises sodium, potassium and/or tetramethylammonium hydroxide.